# EUROPÄISCHE PATENTSCHRIFT

(11) **EP 1 390 768 B1**
(45) Veröffentlichungstag und Bekanntmachung des Hinweises auf die Patenterteilung: **24.02.2010**
(21) Anmeldenummer: 02738015.3
(22) Anmeldetag: 30.04.2002
(51) Int. Cl.: G01R 19/25, G06F 3/033, G01R 31/28

(54) **MESSGERÄT MIT ÜBER EIN BLOCKDIAGRAMM ANSTEUERBAREN FUNKTIONSEINHEITEN**
MEASURING DEVICE WITH FUNCTIONAL UNITS CONTROLLED BY MEANS OF A BLOCK DIAGRAM
APPAREIL DE MESURE A UNITES FONCTIONNELLES POUVANT ETRE COMMANDEES PAR L'INTERMEDIAIRE D'UN SCHEMA FONCTIONNEL

(30) Priorität: 18.05.2001 DE 10124371
(43) Veröffentlichungstag der Anmeldung: 25.02.2004
(60) Teilanmeldung: 08013666.6
(73) Patentinhaber: Rohde & Schwarz GmbH & Co. KG, 81671 München (DE)
(72) Erfinder: PAULY, Andreas, 81673 München (DE); BRAUNSTORFINGER, Thomas, 80796 München (DE); KERNCHEN, Wolfgang, 82054 Sauerlach (DE); DESQUIOTZ, René, 81927 München (DE)
(74) Vertreter: Körfer, Thomas
(86) Internationale Anmeldenummer: PCT/EP2002/004762
(87) Internationale Veröffentlichungsnummer: WO 2002/095426

(56) Entgegenhaltungen:
- DE-A- 19 846 855
- US-A- 5 155 836
- US-A- 5 630 164
- "Lexikon der Eisenbahn" 1981, VEB VERLAG FÜR VERKEHRSWESEN, 6. AUFLAGE , BERLIN Tafeln 56 und 57 * Seite 346 - Seite 347 *

## Beschreibung

Die Erfindung betrifft ein Meßgerät, insbesondere einen Signalgenerator, mit mehreren Funktionseinheiten, beispielsweise mit einer Basisbandeinheit, einer Fadingeinheit, einer Rauscheinheit, einem I/Q-Modulator und einer Hochfrequenzeinheit. Die Verschaltung der Funktionseinheiten ist in gewissen Grenzen variabel und die Funktion der Funktionseinheiten ist aus einer vorgegebenen Palette von Funktionen durch den Benutzer auswählbar.

Bislang war es bei solchen Meßgeräten üblich, die Funktion über Bedientasten '(Soft- und Hardkeys), auszuwählen. Bei dieser Art der Gerätebedienung wird nicht deutlich, in welcher Reihenfolge im Signalfluß die einzelnen Funktionseinheiten miteinander verschaltet sind und auf das zu erzeugende Signal einwirken. Die gerade aktiven Ausgangsbuchsen und die dort anliegenden Signale sind nicht zu erkennen.

Zum technischen Hintergrund sei noch auf die US 5,953,009 verwiesen. Aus dieser Druckschrift geht die Zuweisung von Trigger-Funktionen an einem Meßkanal eines digitalen Oszilloskops durch Anklicken und Verschieben von die Trigger-Funktionen symbolisierenden Ikonen auf der Bedienoberfläche hervor. Der Signalfluß einzelner Funktionseinheiten und die Funktion dieser Funktionseinheiten sind auf der Bedienoberfläche jedoch nicht erkennbar und können auf der Bedienoberfläche nicht ausgewählt werden.

Aus der US 5,630,164 A ist ein Gerät mit mehreren miteinander variabel verschaltbaren Funktionseinheiten und einer optischen Darstellungseinrichtung, mit der die Funktionseinheiten symbolisierende Funktionsblöcke und Signalpfade symbolisierende Verbindungselemente graphisch darstellbar sind, bekannt. Eine Steuereinrichtung steuert die Verschaltung der Funktionseinheiten.

Aus der DE 198 46 855 A1 ist ein Testsystem zum Durchführen einer Operation einer Anwendung bekannt, das eine Testausrüstung durch Anzeigen von Bildern, wie z.B. Graphiksymbolen oder Druckknöpfen auf einem Bildschirm, steuert. Die Steuerung erfolgt durch Auswahl dieser Bilder unter Verwendung einer Zeigevorrichtung.

Aus der US 5, 155, 836 A geht ein Blockdiagrammeditorsystem und ein Verfahren, das auf einer Computer-Workstation implementiert ist, hervor. Auch dort werden Graphiksymbole auf dem Bildschirm der Workstation angezeigt.

Aus dem Lexikon der Eisenbahn, transpress VEB Verlag für Verkehrswesen, Berlin, 6. Auflage, 1981, S. 346, 347, und Tafeln 56 und 57 ist ein Gleisbildstelltisch bekannt, der aus mehreren Gleisbildelementen aufgebaut ist, die durch Tastendruck betätigt werden können.

Der Erfindung liegt die Aufgabe zugrunde, ein Meßgerät mit variabel verschaltbaren Funktionseinheiten, deren Funktion veränderbar ist, zu schaffen, wobei die Auswahl der Verschaltung der Funktionseinheiten und die Auswahl der Funktionen der Funktionseinheiten bedienungsfreundlich realisiert ist.

Die Aufgabe wird durch die Merkmale des Anspruchs 1 gelöst. Die Unteransprüche betreffen vorteilhafte Weiterbildungen der Erfindung.

Der Erfindung liegt das Konzept zugrunde, die Funktionseinheiten symbolisierende Funktionsblöcke auf einer Darstellungseinrichtung (Display) einschließlich ihrer Verbindung graphisch darzustellen, wobei die Funktionsblöcke auf der Darstellungseinrichtung entsprechend der aktuellen Verschaltung der Funktionseinheiten graphisch miteinander verbunden sind.

Dabei kann die Funktion der Funktionseinheit vorteilhaft ausgewählt werden, indem mittels eines Positionierungselements (beispielsweise einem Drehknopf oder einer Maus) ein Cursor an die graphische Position des entsprechenden Funktionsblocks geführt wird und an der Position des Funktionsblocks die gewünschte Funktion aus einer Funktionsauswahlliste (Menü) bzw. einem graphischen Funktionsauswahlfenster (Window) auswählbar ist.

Beispielhafte Funktionseinheiten sind eine Basisbandeinheit, eine Fadingeinheit, eine Rauscheinheit, ein I/Q-Modulator und eine Hochfrequenzeinheit. Diese Einheiten können auch mindestens zweifach vorhanden sein, wobei die Funktionseinheiten der beiden Kanäle in gewissen Grenzen variabel miteinander kombinierbar sind.

Ein Ausführungsbeispiel der Erfindung wird nachfolgend unter Bezugnahme auf die Zeichnung näher beschrieben. In der Zeichnung zeigen:
Fig. 1 ein erstes Beispiel der erfindungsgemäßen graphischen Darstellung der die Funktionseinheiten symbolisierenden Funktionsblöcke;
Fig. 2 ein zweites Beispiel der erfindungsgemäßen graphischen Darstellung der die Funktionseinheiten symbolisierenden Funktionsblöcke;
Fig. 3 ein drittes Beispiel der erfindungsgemäßen graphischen Darstellung der die Funktionseinheiten symbolisierenden Funktionsblöcke;
Fig. 4 ein viertes Beispiel der erfindungsgemäßen graphischen Darstellung der die Funktionseinheiten symbolisierenden Funktionsblöcke;
Fig. 5 ein fünftes Beispiel der erfindungsgemäßen graphischen Darstellung der die Funktionseinheiten symbolisierenden Funktionsblöcke;
Fig. 6 ein sechstes Beispiel der erfindungsgemäßen graphischen Darstellung der die Funktionseinheiten symbolisierenden Funktionsblöcke;
Fig. 7 ein siebtes Beispiel der erfindungsgemäßen graphischen Darstellung der die Funktionseinheiten symbolisierenden Funktionsblöcke; und
Fig. 8 ein Blockschaltbild eines Ausführungsbeispiels eines als erfindungsgemäßes Meßgerät ausgebildeten Signalgenerators.

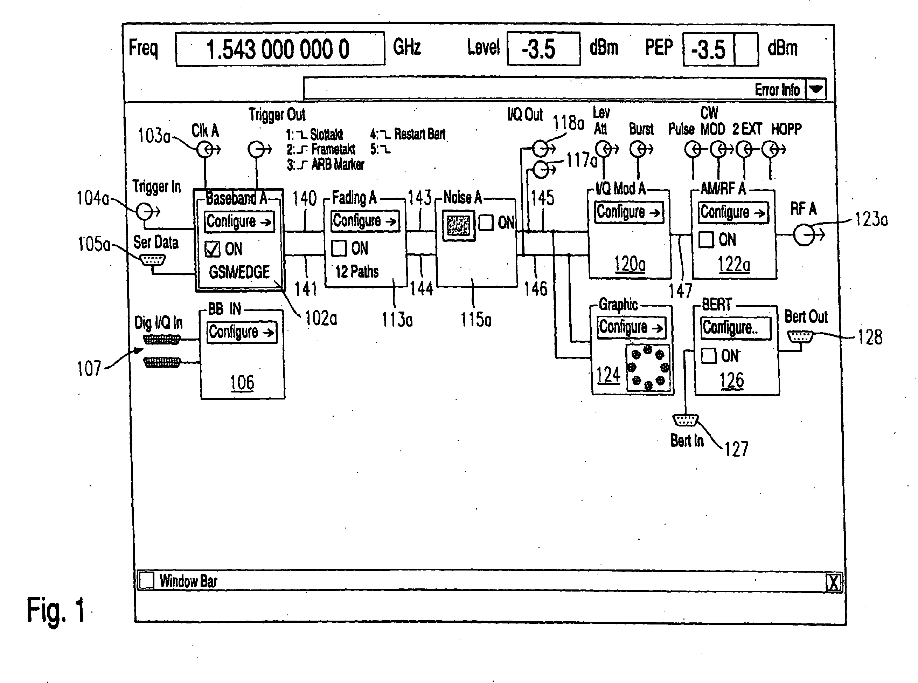

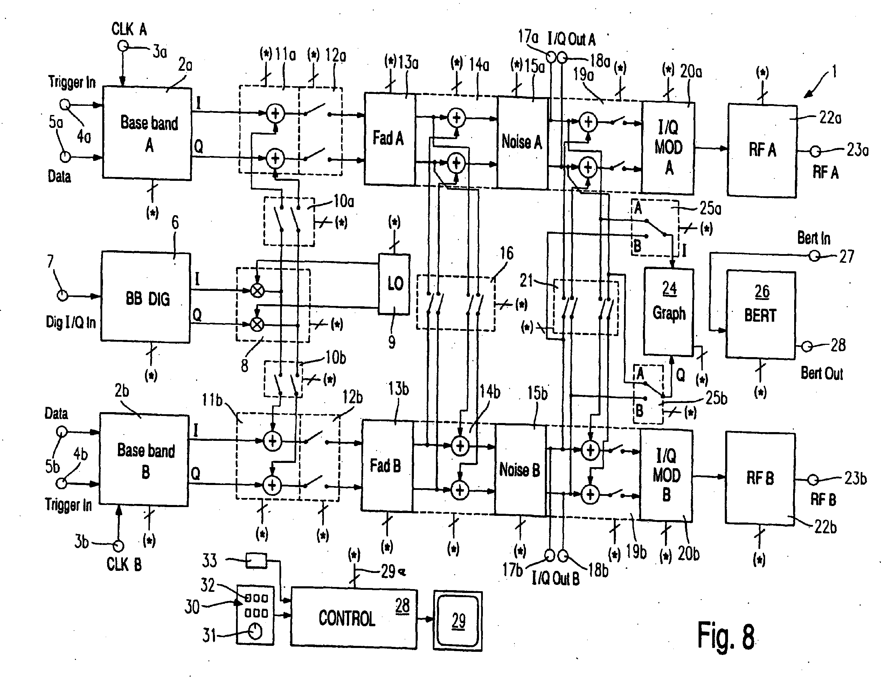

Bevor anhand der Figuren 1 bis 7 auf verschiedene Beispiele der graphischen Darstellung der Funktionsblöcke eingegangen wird, wird zunächst anhand von Fig. 8 ein Blockschaltbild eines Signalgenerators beschrieben, der als erfindungsgemäßes Meßgerät ausgebildet ist.

Der Signalgenerator 1 umfaßt eine erste Basisbandeinheit 2a und eine zweite Basisbandeinheit 2b. Die Basisbandeinheiten 2a und 2b erzeugen an ihren I- und Q-Ausgängen Basisbandsignale nach vorgegebenen, durch den Benutzer auswählbaren Standards, beispielsweise nach dem GSM-Standard, dem GSM-EDGE-Standard oder einem Weitband-CDMA-Standard. Den Basisbandeinheiten 2a, 2b sind an Buchsen 3a bzw. 3b Clock-Signale, an Buchsen 4a bzw. 4b Trigger-Signale und an Buchsen 5a bzw. 5b Modulationsdaten zuführbar. Daneben ist im dargestellten Ausführungsbeispiel eine digitale Basisbandgeneratoreinheit 6 vorhanden, die aus an einer Buchse 7 zugeführten digitalen I/Q-Werten die I- und Q-Komponente eines weiteren Basisband-Signals erzeugt. Das Ausgangssignal des digitalen Basisbandgenerators 6 kann in einer Multipliziereinheit 8, welcher die konstante Frequenz eines einstellbaren lokalen Oszillators 9 zugeführt wird, hochgemischt werden.

Über eine Schalteinheit 10a bzw. eine zweite Schalteinheit 10b wird das ggf. hochgemischte Basisbandsignal der digitalen Basisbandgeneratoreinheit 6 einer digitalen Addiereinheit 11a oder einer digitalen Addiereinheit 11b zugeführt.

Über eine Schalteinheit 12a bzw. eine Schalteinheit 12b wird das Ausgangssignal der Basisbandeinheiten 2a und 2b bzw. der Addiereinheiten 11a und 11b einer Fadingeinheit 13a bzw. 13b zugeführt, die das Basisbandsignal mit einem Fading (variablem Schwund) beaufschlagt. Die Funktionen der Fadingeinheiten 13a und 13b, beispielsweise die Anzahl, die Zeitverzögerung und die Dämpfung der in der Fadingeinheit implementierten Signalverzögerungspfade, können durch den Benutzer festgelegt werden. Die Fadingeinheiten 13a und 13b sind über jeweils eine Addiereinheit 14a bzw. 14b mit jeweils einer Rauscheinheit 15a bzw. 15b verbunden. Die Rauscheinheiten 15a, 15b beaufschlagen das Basisbandsignal mit einem durch den Benutzer festlegbaren Rauschsignal, wobei beispielsweise die Rauschart und der Pegel des von der Rauscheinheit 15a, 15b erzeugten Rauschsignals durch den Benutzer auswählbar ist.

Über eine die Addiereinheiten 14a und 14b verbindende Schalteinheit 16 können anstatt einer separaten Verbindung der jeweiligen Fadingeinheit 13a bzw. 13b mit der zugeordneten Rauscheinheit 15a bzw. 15b die Ausgangssignale der Fadingeinheiten 13a, 13b auch addiert und jeweils einer der beiden Rauscheinheiten 15a bzw. 15b zugeführt werden. Die I/Q-Ausgangssignale am Ausgang der Rauscheinheiten 15a bzw. 15b sind an Buchsen 17a und 18a bzw. 17b und 18b auskoppelbar.

Die Ausgangssignale der Rauscheinheiten 17a und 17b sind über Addier- und Schalteinheiten 19a und 19b I/Q-Modulatoren 20a bzw. 20b zuführbar. Auch hier besteht über eine Schalteinheit 21 die Möglichkeit, die Ausgangssignale der Rauscheinheiten 15a und 15b zu addieren und einem der beiden I/Q-Modulatoren 20a bzw. 20b zuzuführen. Auch hinsichtlich der Funktion des I/Q-Modulators 20a, 20b bestehen mehrere benutzerspezifische Auswahlmöglichkeiten. Beispielsweise kann der I/Q-Modulator 20a, 20b so betrieben werden, daß dieser eine Burst-Sequenz erzeugt und die aktiven Bursts bzw. die Pegel der aktiven Bursts durch die Benutzer ausgewählt werden können.

Die I/Q-Modulatoren 20a und 20b sind jeweils mit einer Hochfrequenzeinheit 22a bzw. 22b verbunden und das Hochfrequenzsignal kann an einer Buchse 23a bzw. 23b abgenommen werden. Beispielsweise können die Ausgangsfrequenz oder mehrere im Frequenzsprungverfahren angesprungene Ausgangsfrequenzen der Hochfrequenzeinheit 22a und 22b durch den Benutzer ausgewählt werden.

Zusätzlich ist eine Signalanzeige 24 vorhanden, die über Schalteinheiten 25a bzw. 25b im Ausführungsbeispiel mit dem Ausgang der Rauscheinheit 15a oder der Rauscheinheit 15b verbindbar ist. Alternativ ist es auch denkbar, daß die Anzeigeeinrichtung 24 direkt mit den Ausgängen der Basisbandeinheiten 2a und 2b verbindbar ist. Die Signalanzeige 24 ermöglicht beispielsweise die Darstellung des Konstellationsdiagramms, so daß der Benutzer die Wirkungsweise des geschalteten Signalpfads überprüfen kann.

Ferner ist ein Bitfehlerratentester (BERT = Bit Error Rate Tester) 26 vorgesehen, dessen Eingangsbuchse 27 ein Signal des Prüflings (DUT) zuführbar ist, wobei an der Ausgangsbuchse 28 die Bitfehlerrate des Signals abgenommen werden kann.

Es können auch noch weitere Funktionseinheiten vorhanden sein und es können weitere Kombinationsvarianten der Funktionseinheiten möglich sein, die aufgrund der Übersichtlichkeit nicht dargestellt sind.

Alle vorstehend beschriebenen Funktionseinheiten 2a, 2b, 6, 8, 9, 10a, 10b, 11a, 11b, 12a, 12b, 13a, 13b, 14a, 14b, 15a, 15b, 16, 19a, 19b, 20a, 20b, 21, 22a, 22b, 24 und 26 sind mit einer Steuereinrichtung 28, beispielsweise einer CPU, über einen Steuerbus 29a, dessen Verbindung mit den Funktionseinheiten über das Symbol (*) gekennzeichnet ist, verbunden. Die Steuereinheit 28 steuert die vom Benutzer gewünschte Verschaltung und Funktion der einzelnen Funktionseinheiten. Die aktuelle Verschaltung der Funktionseinheiten wird auf einer Darstellungseinrichtung (einem Display) 29, das sich zusammen mit den Bedienelementen 30 an der Frontseite des Signalgenerators 1 befinden kann, dargestellt. Dazu ist jeder Funktionseinheit ein graphischer Funktionsblock zugeordnet und die Verbindung der Funktionseinheiten wird durch entsprechende Verbindungselemente, die die Funktionsblöcke miteinander verbinden, auf der Darstellungseinrichtung 29 dargestellt. Die Auswahl der Verbindungen der Funktionsblöcke und die Auswahl der Funktionen der Funktionsblöcke erfolgt entweder mittels eines Drehknopfs 31 und/oder entsprechenden Bedienknöpfen 32 oder über ein verfahrbares Positionierungselement 33 (Maus).

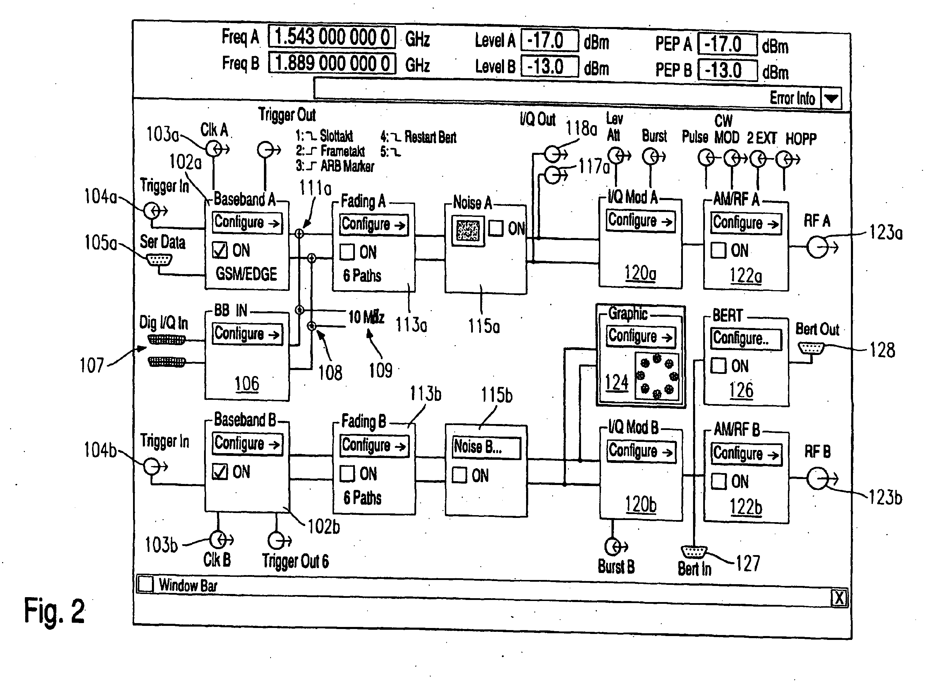

Anhand der Figuren 2 bis 7 werden nachfolgend mehrere Beispiele der Darstellung der den Funktionseinheiten zugeordneten Funktionsblöcke und die zugehörige Auswahl der Funktion der jeweiligen Funktionseinheiten erläutert.

Fig. 1 zeigt die Darstellungsoberfläche der Darstellungseinrichtung (Display) 29 eines ersten Funktionsbeispiels. Erkennbar ist, daß den anhand von Fig. 8 beschriebenen Funktionseinheiten auf der Darstellungseinrichtung 29 dargestellte Funktionsblöcke entsprechen. Die Bezugszeichen der Funktionsblöcke sind jeweils um 100 gegenüber den Bezugszeichen der in Fig. 8 dargestellten Funktionseinheiten erhöht. In Fig. 1 ist ein erster Basisbandblock 102a entsprechend der ersten Basisbandeinheit 2a, ein erster Fadingblock 113a entsprechend der ersten Fadingeinheit 13a und ein erster Rauschblock 115a entsprechend der ersten Rauscheinheit 15a, ein erster I/Q-Modulator-Block 120a entsprechend dem ersten I/Q-Modulator 20a, ein erster Hochfrequenzblock 122a entsprechend der ersten Hochfrequenzeinheit 22a, ein Anzeigebereich 124 entsprechend der Signalanzeige 24 und ein Bitfehlerratentest-Block 126 und entsprechend dem Bitfehlerraten-Tester 26 als Funktionsblöcke dargestellt. Dabei entsprechen die Signal- und Daten-Ein- und Ausgänge 103a, 104a, 105a, 107, 117a, 118a, 123a, 127 und 128 den in Fig. 8 dargestellten Buchsen 3a, 4a, 5a, 7, 17a, 18a, 23a, 27 und 28.

Der Benutzer erkennt durch Blick auf die Darsteilungseinrichtung 29 (das Display) auf einem Blick die bezüglich der aktuellen Funktionen des Signalgenerators 1 ausgewählten und zusammengeschalteten Funktionseinheiten anhand der dargestellten Funktionsblöcke, die diesen Funktionseinheiten entsprechen. Ferner ist sofort erkennbar, welche Ein- und Ausgänge in welcher Weise mit Signalen belegt sind: Der interne Signalfluß und somit die Signalaufbereitung sind für den Benutzer sehr transparent dargestellt. Beispielsweise ist erkennbar, daß die Fadingeinheit 13a vor der Rauscheinheit 15a angeordnet ist, ob das Bursting des Signals im Basisband oder in der Hochfrequenz durchgeführt wird und an welchen Buchsen externe Signale angelegt werden können und wie diese auf den Signalfluß einwirken. Insbesondere wird für den Benutzer sofort erkennbar, ob eine Buchse als Ein- oder Ausgang wirkt. In den Funktionsblöcken sind die aktuellen Konfigurationen erkennbar. Besonders wichtige Parameter sind direkt in den Funktionsblöcken angezeigt. Außerdem ist für den Benutzer verdeutlicht, an welcher Stelle die Signalanzeige 24 in den Signalpfad geschaltet ist.

Fig. 2 zeigt ein zweites Beispiel der graphischen Oberfläche der Darstellungseinrichtung 29.

Neben den bereits anhand von Fig. 1 beschriebenen Funktionsblöcken sind weitere Funktionsblöcke vorhanden, deren Bezugsziffer jeweils um 100 gegenüber der Bezugsziffer der zugehörigen in Fig. 8 dargestellten Funktionseinheit erhöht ist. Gegenüber Fig. 1 zusätzlich vorhanden ist ein die zweite Basisbandeinheit 2a symbolisierender zweiter Basisbandblock 102a, ein die zweite Fadingeinheit 13b symbolisierender zweiter Fadingblock 113a, ein die zweite Rauscheinheit 15b symbolisierender zweiter Rauschblock 115b, ein den zweiten I/Q-Modulator 20b symbolisierender zweiter I/Q-Modulator-Block 120b und eine die zweite Hochfrequenzeinheit 22b symbolisierender zweiter Hochfrequenzblock 122b. Ferner entsprechen die Signal- und Daten-Ein- und Ausgänge 104b, 103b und 123b den in Fig. 8 dargestellten Buchsen 4b, 3b, 23b. Der lokale Oszillator 9 ist durch eine Frequenzangabe an der Position 109 symbolisiert, während die Multipliziereinheit 8 durch die Multipliziersymbole 108 und die Addiereinheit 11a durch die Addiersymbole 111a symbolisiert sind.

Der Benutzer erkennt durch Blick auf die Darstellungseinrichtung 29 unmittelbar die aktuelle Konfiguration des Signalgenerators 1, nämlich daß die beiden Basisbandeinheiten 2a, 2b, Fadingeinheiten 13a, 13b, Rauscheinheiten 15a, 15b und I/Q-Modulatoren 20a, 20b nicht miteinander gekoppelt sind, sondern getrennte Signalpfade bilden, und daß der digitale Basisbandgenerator 6 mit einem Frequenzversatz von 10 MHz zu dem von der ersten Basisbandeinheit 2a erzeugten Basisbandsignal addiert wird.

Ferner ist erkennbar, daß in dem Anzeigebereich 124 das Eingangssignal des zweiten I/Q-Modulators 20b als Konfigurationsdiagramm dargestellt wird.

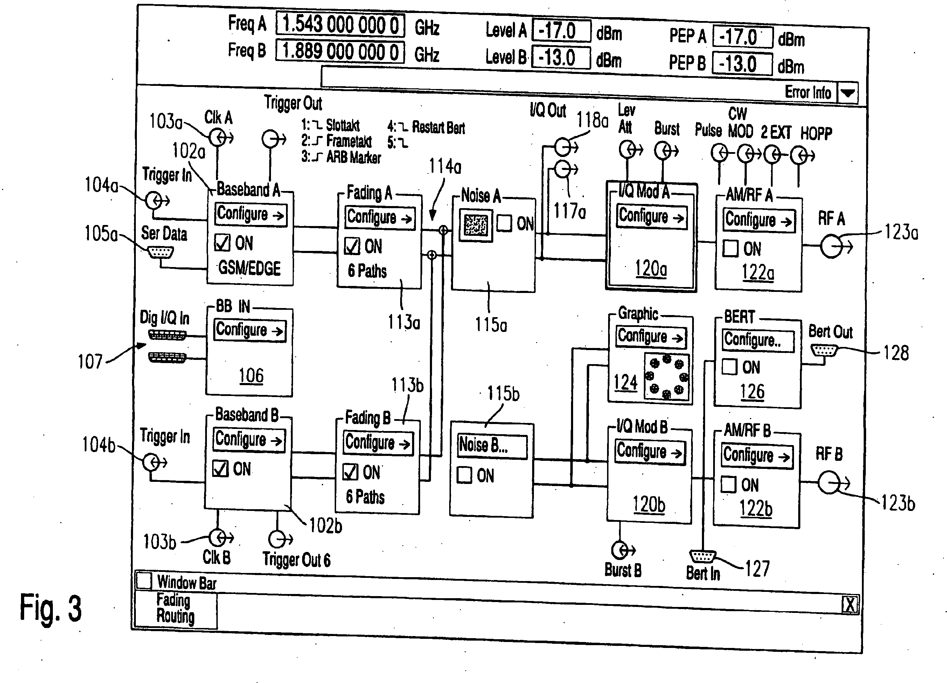

Fig. 3 zeigt ein drittes Beispiel der graphischen Darstellung der Funktionsblöcke. Die meisten der in Fig. 3 dargestellten Funktionsblöcke wurden bereits anhand der Figuren 1 und 2 beschrieben. Zusätzlich vorhanden sind die Addierersymbole 114a zur Symbolisierung der Addiereinheit 14a. Für den Benutzer ist es unmittelbar erkennbar, daß die Ausgänge der beiden Fadingeinheiten 13a und 13b über die Addiereinheit 14a miteinander verbunden sind und somit die addierten Ausgangssignale der Fadingeinheiten 13a und 13b der Rauscheinheit 15a zugeführt werden. Dagegen ist der Eingang der Rauscheinheit 15b nicht belegt.

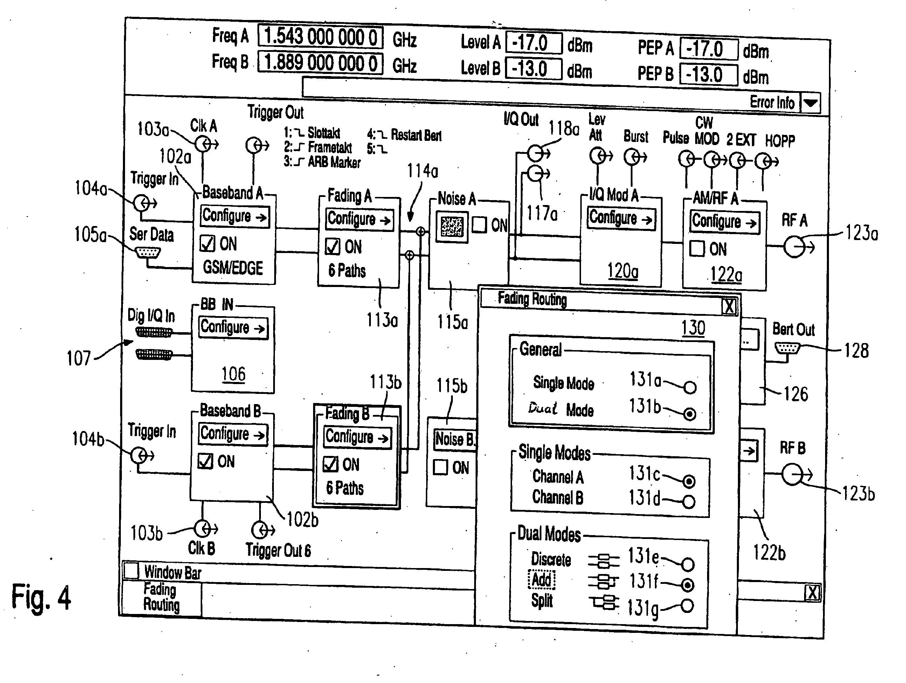

Fig. 4 zeigt ein weiteres Beispiel der graphischen Oberfläche der Darstellungseinrichtung 29. Die dargestellte Konfiguration ist mit der in Fig. 3 dargestellten Konfiguration identisch. Dargestellt ist die Auswahl der Funktion der Fadingeinheiten 13a und 13b als Beispiel für die Funktionsauswahl der Funktionseinheiten. Der Benutzer führt einen Cursor an die graphische Position eines der beiden Fadingblöcke 113a oder 113b. Wie bereits beschrieben symbolisieren die Funktionsblöcke 113a und 113b die Fadingeinheiten 13a und 13b. Die Positionierung des Cursors erfolgt entweder mit einem an der Frontseite des Signalgenerators 1 vorgesehenen Drehknopf 31 oder mit einem extern anschließbaren, verfahrbaren Positionierungselement 33 (Maus). Befindet sich der Cursor innerhalb des Fadingblocks 113a und 113b an dem Button "Configure→" und wird in dieser Position eine entsprechende Taste gedrückt, so öffnet sich das in Fig. 4 unten rechts dargestellte graphische Funktionsauswahlfenster (Window) "Fading Routing" 130.

An diesem Funktionsauswahlfenster 130 kann der Benutzer wiederum mit dem Positionierungselement 33 (Maus oder dem Drehknopf 31) eines der graphischen Auswahlelemente 131a bis 131g auswählen. Durch Tastendruck an der Position des Auswahlelements 131b wird der "Dual Mode" eingeschaltet, d. h. beide Fadingeinheiten 13a und 13b sind aktiv. Nun kann der Benutzer für den "Dual Mode" unter den drei Varianten "Discrete", "Add" und "Split" auswählen. Bei der Betriebsart "Discrete" werden die Fadingeinheiten 13a und 13b nicht miteinander verknüpft, sondern separat der jeweiligen Rauscheinheit 15a bzw. 15b zugeführt. Bei der Betriebsart "Add", die in Fig. 4 ausgewählt ist, werden die Ausgänge der Fadingeinheiten 13a und 13b an der Addiereinheit 14a zusammengeführt. Umgekehrt wird bei der Betriebsart "Split" eine der Basisbandeinheiten 2a oder 2b auf die beiden Fadingeinheiten 13a und 13b aufgeteilt. In den Fadingblöcken 113a und 113b wird unmittelbar angezeigt, wieviele Signalpfade in der jeweiligen Fadingeinheit 13a bzw. 13b aktiv sind (6 Paths).

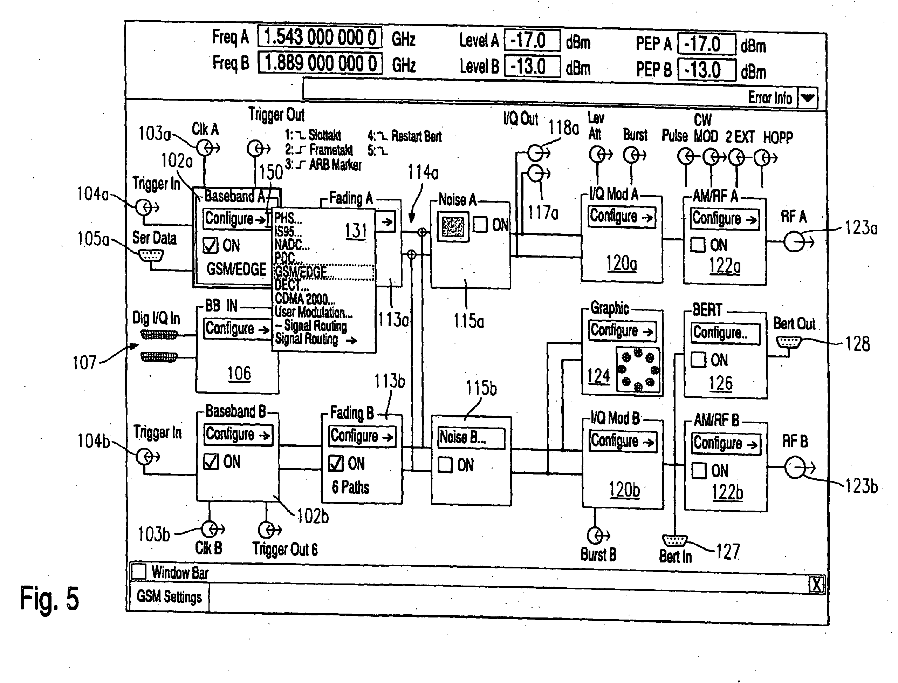

Fig. 5 zeigt ein weiteres Beispiel der graphischen Darstellung der Funktionsblöcke auf der Darstellungseinrichtung 29. Die Konfiguration der Funktionsblöcke entspricht weitgehend derjenigen aus Fig. 3 und 4 mit dem Unterschied, daß der Eingang der zweiten Rauscheinheit 15b zusätzlich mit dem Ausgang der zweiten Fadingeinheit 13b verbunden ist. In Fig. 5 ist die Funktionsauswahl der Basisbandeinheit 2a gezeigt. Wird der Cursor 150 an der Position des Basisbandblocks 102a, der als Funktionsblock die Funktionseinheit der Basisbandeinheit 2a symbolisiert, positioniert, so kann die Funktionsauswahlliste (Menü) 131 geöffnet werden. Hierzu betätigt der Benutzer eine Taste, wenn sich der Cursor 150 an dem Button "Configure→" befindet. In der Funktionsauswahlliste 131 findet der Benutzer eine Liste sämtlicher durch die Basisbandeinheit 2a erzeugbaren Basisbandsignale, wobei die Kurzbezeichnung des jeweiligen Standards angegeben ist. Beispielsweise ist zwischen den Standards "PHS", "IS95", "NADC", "PDC", "GSM/EDGE", "DECT", "CDMA 2000" eine Auswahl möglich. Ferner kann der Benutzer unter dem Menüpunkt "User Modulation" der Basisbandeinheit 2a über die Buchse 5a selbst Modulationdaten zuführen und somit die Modulation benutzerdefiniert festlegen. Der ausgewählte Standard "GSM/EDGE" erscheint in dem Funktionsblock 102a, so daß der Benutzer auch nach Schließen der Funktionsauswahlliste 131 die gewählte Betriebsart der Basisbandeinheit 2a auf einen Blick erkennt.

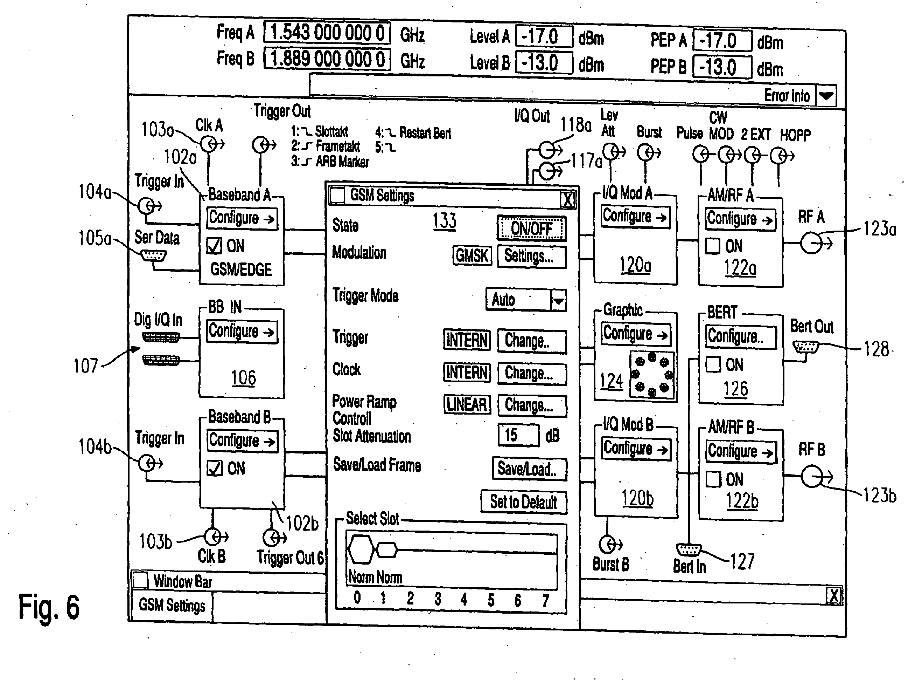

Selektiert der Benutzer in der Funktionsauswahlliste 131 den Standard "GSM/EDGE" so öffnet sich das in Fig. 6 dargestellte graphische Funktionsauswahlfenster (Window) "GSM Settings" 133. In diesem Funktionsauswahlfenster 133 kann der Benutzer verschiedene Einstellungen der Parameter des GSM-Standards vornehmen. Bei Betätigung der entsprechenden Buttons öffnen sich ggf. weitere Funktionsauswahlfenster.

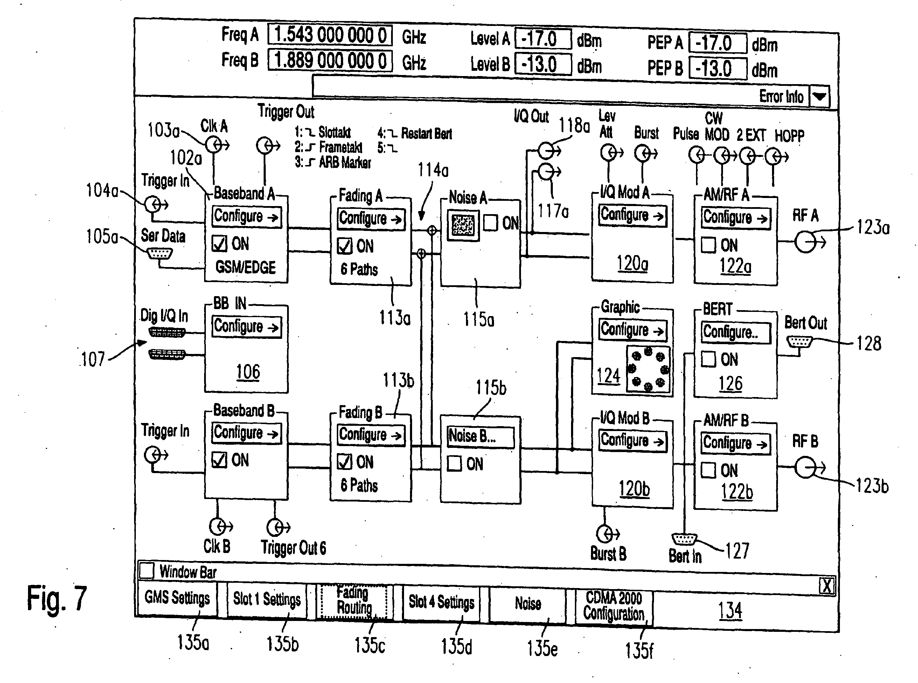

Fig. 7 zeigt ein weiteres Beispiel der graphischen Oberfläche der Darstellungseinrichtung 29. Die Konfiguration der Funktionsblöcke ist mit derjenigen aus Fig. 5 identisch. Zusätzlich sind in einem Fenster "Window Bar" 134 mehrere Buttons 135a bis 135f dargestellt. Durch Betätigung dieser Buttons 135 bis 135f werden die entsprechenden Funktionsauswahlfenster aufgerufen. Beispielsweise öffnet sich bei Betätigung des Buttons 135c das Funktionsauswahlfenster "Fading Routing" 130, das in Fig. 4 dargestellt ist. Bei Betätigung des Buttons 135a öffnet sich das Funktionsauswahlfenster "GSM Settings" 133, das in Fig. 6 dargestellt ist. Auf diese Weise ist eine benutzerfreundliche Verwaltung der aktiven Funktionsauswahlfenster gegeben.

Die Bedienung ist auf diese Art sehr vereinfachte. Die aktuell eingestellten Funktionen der Funktionseinheiten können an den zugeordneten Funktionsblöcken entweder direkt abgelesen werden oder durch Betätigung des Buttons "Configure→" an den entsprechenden Funktionsauswahlfenstern abgelesen werden. Im Gegensatz zu der bisher üblichen Bedienung über Softkeys oder Hardkeys ist die Bedienung weitgehendst selbsterklärend und die Konsultierung eines Benutzerhandbuchs ist nicht erforderlich.

## Patentansprüche

1. Meßgerät (1) mit mehreren Funktionseinheiten (2a, 2b, 13a, 13b,...), die miteinander variabel verschaltbar sind, einer Steuereinrichtung (28), die mit den Funktionseinheiten (2a, 2b, 13a, 13,...) verbunden ist und die die Verschaltung und die Funktionen der Funktionseinheiten (2a, 2b, 13a, 13b,...) festlegt, und einer optischen Darstellungseinrichtung (29),
wobei die Funktionseinheiten (2a, 2b, 13a, 13b,...) symbolisierende Funktionsblöcke (102a, 102b, 113a, 113b,...) auf der Darstellungseinrichtung (29) darstellbar sind und mit Verbindungselementen (140-147) graphisch verbindbar sind, und wobei die Steuereinrichtung (28) die Darstellungseinrichtung (29) so ansteuert, daß die Funktionsblöcke (102a, 102b, 113a, 113b,...) entsprechend der aktuellen Verschaltung der Funktionseinheiten (2a, 2b, 13a, 13b,...) über die Verbindungselemente (140-147) graphisch miteinander verbunden sind.

2. Meßgerät nach Anspruch 1,
**dadurch gekennzeichnet,**
**daß** die Funktionen einer Funktionseinheit (2a) auswählbar sind, indem mittels eines Positionierungselements (30;31) ein Cursor (150) an die graphische Position des entsprechenden Funktionsblocks (102a) führbar ist und an der Position des Funktionsblocks (102a) die gewünschte Funktion der dem Funktionsblock (102a) zugeordneten Funktionseinheit (2a) aus einer Funktionsauswahlliste (131) oder einem graphischen Funktionsauswahlfenster (133) auswählbar und an die Steuereinheit (28) zur Festlegung der Funktion der entsprechenden Funktionseinheit (2a) übermittelbar ist.

3. Meßgerät nach Anspruch 2,
**dadurch gekennzeichnet,**
**daß** eine der Funktionseinheiten eine Basisbandeinheit (2a) ist, wobei die von der Basisbandeinheit (2a) erzeugte Signalart (GSM, GSM-EDGE, WCDMA...) durch Positionieren des Cursors (150) auf den dieser Basisbandeinheit (2a) zugeordneten Funktionsblock (102a) auswählbar ist.

4. Meßgerät nach Anspruch 3,
**dadurch gekennzeichnet,**
**daß** eine der Funktionseinheiten eine der Basisbandeinheit (2a) nachgeschaltete Fadingeinheit (13a) ist, wobei die Anzahl, die Zeitverzögerung und die Dämpfung der in der Fadingeinheit (13a) vorgesehenen Signalpfade durch Positionieren des Cursors (15a) auf den dieser Fadingeinheit (13a) zugeordneten Funktionsblock (113a) auswählbar sind.

5. Meßgerät nach Anspruch 4,
**dadurch gekennzeichnet,**
**daß** eine der Funktionseinheiten eine der Basisbandeinheit (2a) oder der Fadingeinheit (13a) nachgeschaltete Rauscheinheit (15a) ist, wobei die Rauschart und der Pegel des von der Rauscheinheit (15a) erzeugten Rauschsignals durch Positionieren des Cursors (150) auf den dieser Rauscheinheit (15a) zugeordneten Funktionsblock (115a) auswählbar sind.

6. Meßgerät nach einem der Ansprüche 3 bis 5,
**dadurch gekennzeichnet,**
**daß** eine der Funktionseinheiten ein der Basisbandeinheit (2a), der Fadingeinheit (13a) oder der Rauscheinheit (15a) nachgeschalteter I/Q-Modulator (20a) ist, mit dem ein aus einer Burst-Sequenz bestehendes Signal erzeugbar ist, wobei die aktiven Bursts und die Pegel der Bursts durch Positionieren des Cursors (150) auf den diesem I/Q-Modulator (20a) zugeordneten Funktionsblock (120a) auswählbar sind.

7. Meßgerät nach Anspruch 6,
**dadurch gekennzeichnet,**
**daß** eine der Funktionseinheiten eine dem I/Q-Modulator (20a) nachgeschaltete Hochfrequenzeinheit (22a) ist, wobei eine Ausgangsfrequenz bzw. mehrere im Frequenzsprungverfahren angesprungene Ausgangsfrequenzen
durch Positionieren des Cursors (150) auf den dieser Hochfrequenzeinheit (22a) zugeordneten Funktionsblock (122a) auswählbar ist bzw. sind.

8. Meßgerät nach Anspruch 6 oder 7,
**dadurch gekennzeichnet,**
**daß** in einem Anzeigebereich (124) auf der Darstellungseinrichtung (29) ein Konstellationsdiagramm des signals am Eingang des I/Q-Modulators (20a) und/oder am Ausgang der Basisbandeinheit (2a) und/oder der Fadingeinheit (13a) darstellbar ist.

9. Meßgerät nach Anspruch 7 oder 8,
**dadurch gekennzeichnet,**
**daß die** Basisbandeinheit (2a, 2b), die Fadingeinheit (13a, 13b), die Rauscheinheit (15a, 15b), der I/Q-Modulator (20a, 20b) und die Hochfrequenzeinheit (22a, 22b) mindestens zweifach vorhanden sind.

10. Meßgerät nach einem der Ansprüche 3 bis 9,
**dadurch gekennzeichnet,**
**daß** eine digitale Basisbandgeneratoreinheit (6) vorgesehen ist, deren Ausgangssignal zu dem Ausgangssignal einer Basisbandeinheit (2a, 2b) addierbar ist.

## Claims

1. A measuring device (1) with several functional units (2a, 2b, 13a, 13b, ...), which can be configured with one another in a variable manner, a control device (28), which is connected to the functional units (2a, 2b, 13a, 13b, ...) and which specifies the configuration and the functions of the functional units (2a, 2b, 13a, 13b, ...), and a visual display device (29),
wherein functional blocks (102a, 102b, 113a, 113b,...) symbolising the functional units (2a, 2b, 13a, 13b, ...) can be presented on the display device (29) and can be graphically connected with connecting elements (140-147), and wherein the control device (28) controls the display device (29) in such a manner that the functional blocks (102a, 102b, 113a, 113b,...) are graphically connected to one another via the connecting elements (140-147) corresponding to the current configuration of the functional units (2a, 2b, 13a, 13b, ...).

2. The measuring device according to claim 1,
**characterised in that**
the functions of a functional unit (2a) can be selected, **in that**, by means of a positioning element (30; 31), a cursor (150) can be guided to the graphic position of the corresponding functional block (102a) and, at the position of the functional block (102a), the required function of the functional unit (2a) assigned to the functional block (102a) can be selected from a function-selection list (131) or a graphic function-selection window (133) and communicated to the control unit (28) for the specification of the function of the corresponding functional unit (2a).

3. The measuring device according to claim 2,
**characterised in that**
one of the functional units is a baseband unit (2a), wherein the signal type (GSM, GSM-EDGE, WCDMA...) generated by the baseband unit (2a) can be selected by positioning the cursor (150) on the functional block (102a) assigned to this baseband unit (2a).

4. The measuring device according to claim 3,
**characterised in that**
one of the functional units is a fading unit (13a) connected downstream of the baseband unit (2a), wherein the number, the time delay and the attenuation of the signal paths provided in the fading unit (13a) can be selected by positioning the cursor (15a) on the functional block (113a) assigned to this fading unit (13a).

5. The measuring device according to claim 4,
**characterised in that**
one of the functional units is a noise unit (15a) connected downstream of the baseband unit (2a) or the fading unit (13a), wherein the noise type and the level of the noise signal generated by the noise unit (15a) can be selected by positioning the cursor (150) on the functional block (115a) assigned to this noise unit (15a).

6. The measuring device according to any one of claims 3 to 5,
**characterised in that**
one of the functional units is an I/Q modulator (20a) connected downstream of the baseband unit (2a), the fading unit (13a) or the noise unit (15a), with which a signal consisting of a burst sequence can be generated, wherein the active bursts and the level of the bursts can be selected by positioning the cursor (150) on the functional block (120a) assigned to this I/Q modulator (20a).

7. The measuring device according to claim 6,
**characterised in that**
one of the functional units is a high-frequency unit (22a) connected downstream of the I/Q modulator (20a), wherein an output frequency or respectively several output frequencies approached through the frequency hopping method is/are selectable by positioning the cursor (150) on the functional block (122a) assigned to this high-frequency unit (22a).

8. The measuring device according to claim 6 or 7,
**characterised in that** a constellation diagram of the signal at the input of the I/Q modulator (20a) and/or at the output of the baseband unit (2a) and/or of the fading unit (13a) can be presented in a display region (124) on the display device (29).

9. The measuring device according to claim 7 or 8,
**characterised in that**
the baseband unit (2a, 2b), the fading unit (13a, 13b), the noise unit (15a, 15b), the I/Q modulator (20a, 20b) and the high-frequency unit (22a, 22b) are present at least twofold.

10. The measuring device according to any one of claims 3 to 9,
**characterised in that**
a digital baseband generator unit (6) is provided, the output signal of which can be added to the output signal of a baseband unit (2a, 2b).

## Revendications

1. Appareil de mesure (1), avec plusieurs unités fonctionnelles (2a, 2b, 13a, 13b, ...), pouvant être connectées variablement entre elles, une installation de commande (28) qui est reliée aux unités fonctionnelles (2a, 2b, 13a, 13b) et qui détermine la connexion et les fonctions des unités fonctionnelles (2a, 2b, 13a, 13b...) et une installation de représentation optique (29),
où des blocs fonctionnels (102a, 102b, 113a, 113b, ...) symbolisant les unités fonctionnelles (2a, 2b, 13a, 13b, ...) peuvent être représentés sur l'installation de représentation (29) et peuvent être reliées graphiquement au moyen d'éléments de liaison (140-147), et où l'installation de commande (28) commande l'installation de représentation (29) de façon que les blocs fonctionnels (102a, 102b, 113a, 113b, ...) soient reliés graphiquement entre eux, conformément à la connexion actuelle des unités fonctionnelles (2a, 2b, 13a, 13b, ...), au moyen des éléments de liaison (140-147).

2. Appareil de mesure selon la revendication 1,
**caractérisé en ce que**
les fonctions d'une unité fonctionnelle (2a) peuvent être sélectionnées, **en ce qu'**au moyen d'un élément de positionnement (30; 31), un curseur (150) peut être guidé à la position graphique du bloc fonctionnel correspondant (102a), et la fonction souhaitée de l'unité fonctionnelle (2a) associée au bloc fonctionnel (102a) peut être sélectionnée d'une liste de sélection de fonction (131) ou d'une fenêtre de sélection de fonction graphique (133) et peut être transmise à l'unité de commande (28) pour déterminer la fonction de l'unité fonctionnelle correspondante (2a).

3. Appareil de mesure selon la revendication 2,
**caractérisé en ce que**
l'une des unités fonctionnelles est une unité de bande de base (2a), où le type de signal (GSM, GSM-EDGE, WCDMA...) produit par l'unité de bande de base (2a) peut être sélectionné par le positionnement du curseur (150) sur le bloc fonctionnel (102a) associé à cette unité de bande de base (2a).

4. Appareil de mesure selon la revendication 3,
**caractérisé en ce que**
l'une des unités fonctionnelles est une unité d'évanouissement (13a) disposée en aval de l'unité de bande de base (2a), où le nombre, le retard de temps et l'amortissement des chemins de signal prévus dans l'unité d'évanouissement (13a) peuvent être sélectionnés par le positionnement du curseur (15a) sur le bloc fonctionnel (113a) associé à cette unité d'évanouissement (13a).

5. Appareil de mesure selon la revendication 4,
**caractérisé en ce que**
l'une des unités fonctionnelles est une unité de bruit (15a) disposée en aval de l'unité d'évanouissement (13a), où le type de bruit et le niveau du signal de bruit produit par l'unité de bruit (15a) peuvent être sélectionnés par le positionnement du curseur (150) sur le bloc fonctionnel (115a) associé à cette unité de bruit (15a).

6. Appareil de mesure selon la revendication 3 à 5,
**caractérisé en ce que**
l'une des unités fonctionnelles est un modulateur I/Q (20a) disposé en aval de l'unité de bruit (15a), par lequel un signal constitué d'une séquence de salves peut être produit, où les salves actives et le niveau des salves peuvent être sélectionnés par le positionnement du curseur (150) sur le bloc fonctionnel (120a) associé à ce modulateur I/Q (20a).

7. Appareil de mesure selon la revendication 6,
**caractérisé en ce que**
l'une des unités fonctionnelles est une unité haute fréquence montée en aval du modulateur I/Q (20a), où une fréquence de sortie respectivement plusieurs fréquences de sortie abordées par un procédé de saut de fréquences peut respectivement peuvent être sélectionnées par le positionnement du curseur (150) sur le bloc fonctionnel (122a) associé à cette unité haute fréquence (22a).

8. Appareil de mesure selon la revendication 6 ou
7, **caractérisé en ce que**
dans une zone d'affichage (124) sur l'installation de représentation (29), un diagramme de constellation du signal peut être représenté à l'entrée du modulateur I/Q (20a) et/ou à la sortie de l'unité de bande de base (2a) et/ou de l'unité d'évanouissement (13a).

9. Appareil de mesure selon la revendication 7 ou
8, **caractérisé en ce que**
l'unité de bande de base (2a, 2b), l'unité d'évanouissement (13a, 13b), l'unité de bruit (15a, 15b), le modulateur I/Q (20a, 20b) et l'unité haute fréquence (22a, 22b) sont présents au moins en double.

10. Appareil de mesure selon la revendication 3 à 9,
**caractérisé en ce qu'**
est prévue une unité génératrice de bande de base numérique (6) dont le signal de sortie peut être additionné avec le signal de sortie d'une unité de bande de base (2a,2b).
